Europäisches Patentamt

**European Patent Office**

Office européen des brevets

(19)

(11) Numéro de publication: **0 254 625**
**B1**

(12) **FASCICULE DE BREVET EUROPEEN**

(45) Date de publication du fascicule du brevet:
25.04.90

(51) Int. Cl.⁴: **H01J 37/252**, H01J 37/02,
G01N 23/225

(21) Numéro de dépôt: **87401592.8**

(22) Date de dépôt: **07.07.87**

(54) **Procédé et dispositif pour la décharge d'échantillons isolants lors d'une analyse ionique.**

(30) Priorité: **23.07.86 FR 8610681**

(43) Date de publication de la demande:
**27.01.88 Bulletin 88/4**

(45) Mention de la délivrance du brevet:
**25.04.90 Bulletin 90/17**

(84) Etats contractants désignés:
**DE FR GB**

(56) Documents cités:
**EP-A- 0 104 818**

**PATENT ABSTRACTS OF JAPAN,**
**vol. 9, no. 274 (E-354)[1997], 31 octobre 1985; &**
**JP-A-60 117 532 (SHIMAZU SEISAKUSHO**
**K.K.) 25-06-1985**
**PATENT ABSTRACTS OF JAPAN,**
**vol. 7, no. 162 (E-187)[1307], 15 juillet 1983; &**
**JP-A-58 71 546 (FUJITSU K.K.) 28-04-1983**
**PATENT ABSTRACTS OF JAPAN,**
**vol. 7, no. 243 (E-207)[1388], 28 octobre 1983; &**
**JP-A-58 131 731 (FUJITSU K.K.) 05-08-183**

(73) Titulaire: **CAMECA, 103, Boulevard Saint-Denis,**
**F-92400 Courbevoie(FR)**

(72) Inventeur: **Slodzian, Georges, THOMSON-CSF**
**SCPI 19, avenue de Messine, F-75008 Paris(FR)**

(74) Mandataire: **Turlèque, Clotilde et al, THOMSON-CSF**
**SCPi, F-92045 PARIS LA DEFENSE CEDEX 67(FR)**

## Description

L'invention se rapporte aux analyseurs ioniques et plus particulièrement à l'analyse ionique d'échantillons isolants.

Pour l'analyse des échantillons solides, des analyseurs ioniques sont couramment utilisés. Si les éléments intéressants à analyser émettent en ions négatifs, l'échantillon est polarisé négativement et les ions négatifs émis sont analysés. Par contre si les éléments intéressants à analyser émettent en ions positifs, alors l'échantillon doit être polarisé positivement, et ce sont les ions positifs qui peuvent alors être analysés. Pour les échantillons dans lesquels se forment des zones isolantes, ou pour les échantillons isolants, l'émission des particules chargées crée à la surface de l'échantillon une charge de surface qu'il est nécessaire de compenser pour obtenir des images convenables de l'échantillon.

On connait par la demande de brevet français n° 83 00538 déposée le 14 janvier 1983 (voir aussi EP-A 0 114 765), un procédé et un dispositif pour l'analyse ionique d'échantillons isolants à partir des ions secondaires négatifs émis par l'échantillon. Le procédé de décharge du champ imagé, et le dispositif correspondant, consiste à diriger vers la surface analysée, en plus du faisceau d'ions primaires d'analyse, un faisceau auxiliaire d'électrons qui compense exactement les charges positives qui ont tendance à se créer à la surface de l'échantillon et à perturber les images si aucune solution n'est prise pour les neutraliser.

Pour l'analyse d'échantillons isolants dans lesquels l'analyse est réalisée à partir des ions secondaires positifs créés lors du bombardement ionique, la cible est polarisée positivement pour repousser ces ions secondaires positifs créés par l'impact du faisceau primaire. Une solution, analogue à celle décrite ci-dessus pour l'analyse à partir des ions négatifs, consisterait à remplacer le faisceau auxiliaire des électrons par un faisceau auxiliaire monocinétique d'ions positifs ; mais cette solution n'est pas intéressante car elle conduit à un montage trop compliqué du fait que le champ magnétique qui amènerait ce faisceau auxiliaire sur l'axe de l'objectif à émission ionique devrait être beaucoup plus intense que celui utilisé antérieurement, et que son effet sur les ions secondaires ne pourrait plus être compensé aussi aisément. De plus, il serait nécessaire que la surface de l'isolant ait tendance à développer dans tous les cas une charge négative lors du bombardement ionique ; or ce n'est pas le cas lorsque le bombardement ionique est réalisé avec des ions primaires positifs. Pour obtenir une compensation il faudrait donc bombarder la surface de l'échantillon soit avec des atomes neutres rapides, soit avec des ions négatifs, soit encore disposer en supplément d'un faisceau auxiliaire d'électrons, mais le système devient alors plus compliqué.

D'autres solutions ont été proposées, toujours dans le cas où l'analyse porte sur les ions positifs émis par la cible : une grille métallique est déposée par évaporation sur la surface. Les plages isolantes de l'échantillon reçoivent, en plus du faisceau d'ions primaires, des électrons secondaires de faible énergie émis par la grille et des électrons de haute énergie produits sur l'électrode d'accélération et attirés par l'échantillon.

Ce faible flux électronique sur le champ imagé peut cependant être utilisé pour la compensation à condition que la densité du bombardement d'ions primaires soit abaissée suffisamment, tout en maintenant l'intensité totale du faisceau d'ions primaires sur la cible constante. Il est alors possible d'obtenir un état d'équilibre électrique, où la surface isolante est pratiquement équipotentielle et où l'écart de potentiel avec le film conducteur, est quasi nul, en modulant la densité du faisceau d'ions primaires dans le champ imagé. Cet abaissement a des inconvénients car les courants d'ions secondaires utilisés pour l'imagerie sont alors faibles. De plus le réglage de la densité du faisceau primaire est délicat, car il n'est obtenu qu'en faisant varier la focalisation du faisceau d'ions primaires par action sur l'excitation des condenseurs; or, du fait des diaphragmes présents dans la colonne primaire, cette opération peut aussi modifier l'intensité totale du faisceau primaire arrivant sur la cible. Enfin, la plage bombardée est agrandie inutilement et en outre les nouvelles régions touchées peuvent émettre différemment, ce qui entraine une modification fu flux d'électrons secondaires qui tend à augmenter la difficulté du réglage.

L'invention a pour objet un procédé et le dispositif correspondant pour l'analyse ionique d'échantillons isolants, adaptés au cas où l'image est formée à partir des ions secondaires positifs, qui n'a pas les inconvénients mentionnés ci-dessus.

Un procédé ainsi qu'un dispositif selon les préambules des revendications 1, 6 et 7 sont illustrés dans PATENT ABSTRACTS OF JAPAN, vol. 9, no. 274(E-354)[1997], 31 octobre 1985; & JP-A 60 117 532.

Suivant l'invention, un procédé d'analyse ionique d'échantillon isolant émettant en ions secondaire positifs sous l'impact d'un faisceau de bombardement primaire d'ions positifs, ces ions secondaires positifs étant accélérés par un champ électrostatique créé dans un espace d'accélération entre une électrode d'accélération et une surface de l'échantillon portée à un potentiel positif par rapport à cette électrode, est caractérisé en ce que la charge positive créée dans le champ imagé de l'échantillon est compensée par des électrons secondaires émis par l'électrode d'accélération sous l'impact de particules émises par l'échantillon, des moyens de focalisation étant prévus dans l'espace d'accélération pour renvoyer sur le champ imagé la quantité d'électrons secondaires juste nécessaire à la compensation.

L'invention a également pour objet un dispositif d'analyse ionique d'échantillon isolant pour l'analyse des ions positifs émis par le champ imagé de l'échantillon sous l'impact d'un faisceau d'ioins primaires positifs, comportant une source d'ions primaires, une colonne primaire pour amener ces ions primaires sur le champ imagé de l'échantillon, un dispositif collecteur d'ions secondaires positifs comportant notamment une électrode d'accélération, et un spectromère de masse, caractérisé en ce qu'il comporte en outre une électrode supplémentaire placée entre le dispositif collecteur et l'échantillon et susceptible d'être polarisée à une tension intermédiaire entre celle d'une surface de l'électrode d'accélération et celle de l'échantillon, et des moyens de réglage de cette tension intermédiaire.

L'invention sera mieux comprise et d'autres caractéristiques apparaîtront à l'aide de la description qui suit en référence aux figures annexées.

- La figure 1 est un schéma synoptique simplifié du dispositif d'analyse ionique suivant l'invention ;
- La figure 2 est un schéma de détail qui illustre le dispositif suivant l'invention ;
- Les figures 3a et 3b montrent en coupe et de dessus l'échantillon et la répartition des charges, ainsi que les courants induits ;
- Les figures 4a et 4b sont des diagrammes vectoriels explicatifs.

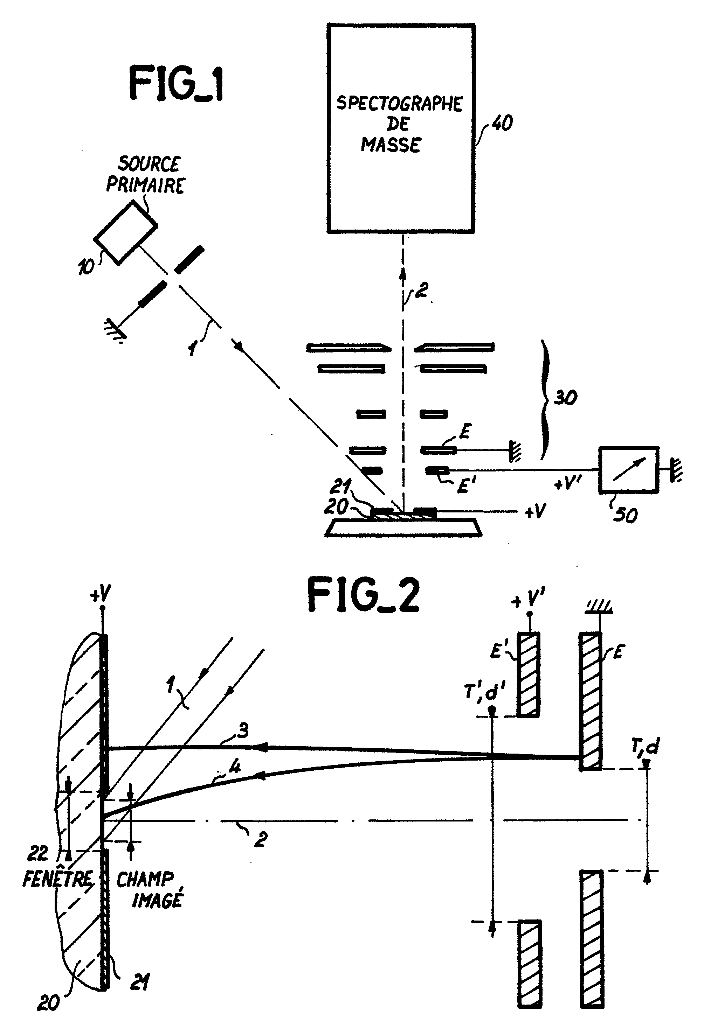

Avant de décrire précisément l'objet de l'invention, on décrit ci-après en référence à la figure 1 les éléments essentiels de l'analyseur. Cet analyseur comporte une source d'ions primaires 10, polarisée positivement à 10kV par exemple, bombardant un faisceau ionique primaire 1 sur une cible à la surface d'un échantillon isolant 20, dont la section plane et polie est recouverte d'un film conducteur 21 dans lequel une fenêtre 22 a été ouverte pour mettre à nu la surface de l'isolant. Le film conducteur 21 est porté à une tension +V. Un dispositif collecteur 30 formé d'un ensemble de lentilles électrostatiques comporte en particulier l'électrode d'accélération E portée à la masse. Un spectrographe de masse 40, non décrit ici, effectue l'analyse. Le flux d' ions secondaires positifs produit à la surface de la cible par ce bombardement est accéléré par le champ électrostatique créé entre l'électrode E et l'échantillon suivant l'axe 2. Ces ions positifs produits s'échappent de l'espace d'accélération par un trou circulaire T percé dans l'électrode E. Cette électrode E est également bombardée elle-même par un flux de particules venant de la cible : en effet la cible émet des ions positifs, renvoie des ions rétrodiffusés ou des atomes rétrodiffusés, ainsi que des atomes neutres arrachés à la surface par le bombardement ionique. L'électrode est aussi frappée par des ions secondaires émis par la surface avec des énergies initiales trop fortes et dans des directions qui s'écartent trop de la direction normale pour passer par le trou T. Un certain nombre de ces particules ont une énergie d'impact suffisante pour produire des électrons secondaires à la surface de l'électrode E. Ces électrons sont alors attirés par l'objet puisque celui-ci est polarisé positivement.

Une caractéristique intéressante du flux de particules qui frappe l'électrode E en provenance de l'objet est que ce flux est proportionnel au flux d'ions primaires positifs d'analyse. Il en est de même du flux d'électrons secondaires produits par cette électrode qui est donc également proportionnel au flux d'ions primaires. Ces électrons secondaires sont renvoyés vers l'objet mais dans des directions quelconques, et seul un petit nombre de ces électrons arrive sur le champ imagé. En effet, ce champ imagé est centré sur l'axe du système et donc sur l'axe du trou T percé dans l'électrode E, et son diamètre atteint exceptionnellement 0,4 mm c'est-à-dire qu'il est en général plus petit que le diamètre du trou T qui est en général compris entre 0,5 mm et 1,5 mm. Les électrons secondaires émis par l'électrode E sur le pourtour du trou T, et perpendiculairement à cette électrode frappent l'échantillon en dehors du champ imagé. Le calcul montre que, pour que les électrons atteignent le centre du champ imagé, il est nécessaire qu'ils soient émis dans une direction faisant un angle important avec la normale, et qu'ils soient émis avec une énergie relativement élevée, de l'ordre d'une dizaine d'électronvolts. Or les électrons secondaires ont une distribution énergétique dont le maximum se situe à quelques électronvolts. En conséquence le flux d'électrons sur le champ imagé est très inférieur au flux total qui revient sur l'échantillon.

Suivant l'invention, on utilise pour décharger la surface isolante de l'échantillon dans le champ imagé les électrons secondaires émis par l'électrode E, en plaçant entre l'électrode E et l'échantillon, des moyens de focalisation de ces électrons secondaires vers le champ image, par exemple électrostatique, en plaçant parallèlement à E, une électrode E' percée d'un trou circulaire T' centré sur le même axe que T, mais dont le diamètre d' est supérieur au diamètre d de T. L'électrode E' est portée à un potentiel ajustable, au moyen d'une source de tension ajustable 50 de telle sorte que les électrons secondaires émis par l'électrode E sur une couronne circulaire entourant le trou T soient plus ou moins focalisés vers le champ imagé. La figure 2 représente plus en détails l'échantillon, les électrodes E et E' et l'espace d'accélération. En l'absence d'électrode E' la trajectoire des électrons secondaires émis par l'électrode E peuvent être celle référencée 3 sur la figure 2. Par contre pour une tension V' appliquée à l'électrode E' la trajectoire des électrons est modifiée et peut être celle de la référence 4. Ainsi, par rapport aux systèmes antérieurs, une fraction beaucoup plus importante des électrons secondaires émis par l'électrode E est utilisable pour la décharge de l'échantillon isolant. La densité de ce flux électronique est ajustable par commande de la tension appliquée à l'électrode E', ce qui facilite les réglages. En effet, pour une densité du faisceau d'ions primaires donnée, le réglage est obtenu en agissant sur la tension appliquée à l'électrode E', jusqu'à l'obtention d'une surface isolante quasi équipotentielle entre le film conducteur et la fenêtre imagée.

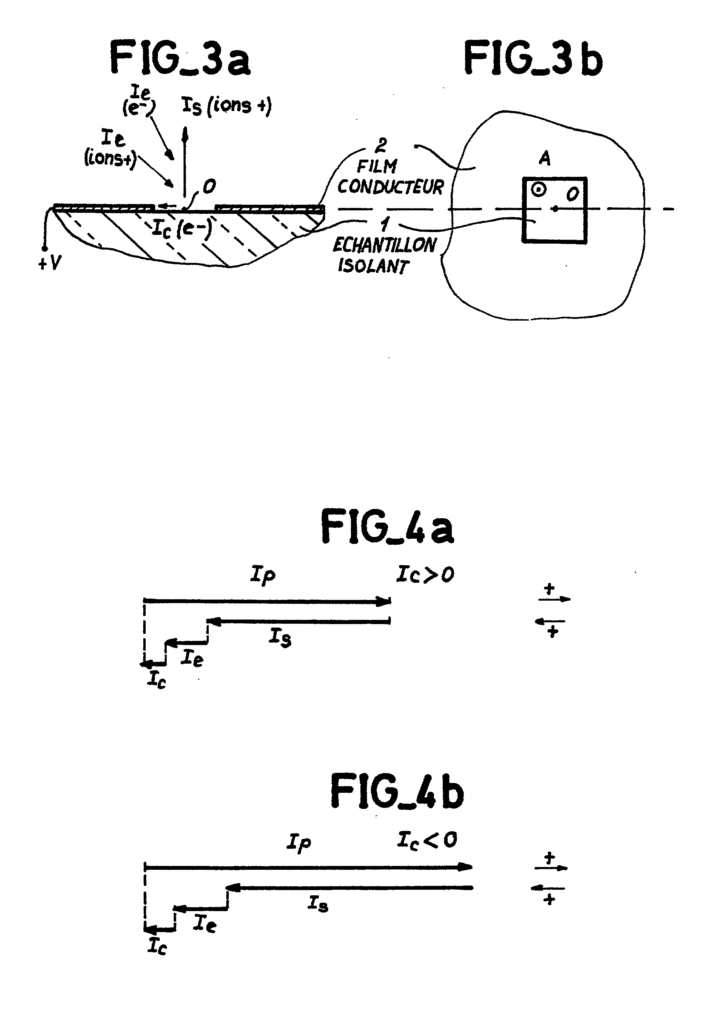

Les figures 3a et 3b montrent respectivement en coupe et de dessus l'échantillon 20 recouvert du film conducteur 21 dans lequel la fenêtre 22 a été formée et les flux des particules reçus et émis.

Sur le film conducteur 21, l'énergie d'impact du bombardement électronique dépend du potentiel positif V auquel est porté l'objet. En l'absence de compensation, sur la surface de l'isolant, le potentiel électrostatique n'est pas constant. Comme il est partout inférieur à V, l'énergie d'impact y est donc plus faible que sur le conducteur. Au point O, centre de l'aire isolante, l'écart de potentiel entre film conducteur et isolant est maximal. La valeur de cet écart dépend de la configuration géométrique : isolant massif, film isolant mince sur support conducteur, ...

Considérons maintenant une petite aire entourant un point A de la surface isolante, figure 3b. Elle reçoit un courant $I_p$ d'ions primaires positifs et un courant électronique de compensation $I_e$ , elle émet un courant $I_s$ de particules positives et évacue un courant $I_c$ par conduction vers le film : $I_c = I_p - I_s - I_e$ . Selon l'invention, le flux électronique $I_e$ est rendu proportionnel au flux d'ions primaires $I_p$ .

Les figures 4a et 4b sont deux diagrammes vectoriels qui montrent comment s'effectue la compensation, à tension de commande V' constante, lorsque l'intensité du faisceau primaire varie ; l'équilibre n'est pas modifié, $I_p$ , $I_e$ , et $I_s$ , et $I_c$ variant dans les mêmes proportions.

La décharge de l'échantillon isolant par les moyens décrits ci-dessus n'est bien entendu utilisable que si le nombre d'ions positifs quittant la surface est inférieur au nombre d'ions primaires positifs arrivant sur la cible. Dans une situation où le nombre d'ions positifs quittant la surface serait supérieur au nombre d'ions primaires positifs arrivant sur la cible, il serait nécessaire de changer la nature ou l'énergie des ions primaires pour rétablir l'équilibre. Cette exception ne devrait pas être fréquente.

Par ailleurs, si le bombardement électronique induit une conductivité très faible à la surface de l'échantillon, il peut être impossible d'aboutir à une surface isolante équipotentielle. Il peut même être difficile d'atteindre dans ce cas un équilibre électrique à cause de la difficulté qu'il y a à régler l'excitation de l'électrode supplémentaire E' pour que le flux électronique compense exactement la différence entre le flux d'arrivée des ions primaires et le flux de départ des ions positifs émis, secondaires et rétrodiffusés. La conductivité induite reste donc nécessaire pour rétablir l'équilibre. Bien entendu plus on se rapproche de la compensation exacte moins la conductivité intervient, de sorte qu'une conductivité même faible peut être suffisante. Cependant une difficulté persiste du fait de la période transitoire pendant laquelle la compensation n'est pas atteinte et où l'on prend le risque de passer par des écarts importants menant très rapidement à des claquages.

Pour résoudre ce problème, il est possible d'effectuer une phase de réglage préalable en utilisant un faisceau d'ions primaires de densité très faible, qui ne permet pas d'obtenir des signaux élevés, mais à partir duquel l'état d'équilibre est obtenu par réglage de l'excitation de l'électrode supplémentaire E'. Du fait que le faisceau d'électrons secondaires émis par l'électrode E' est proportionnel au faisceau d'ions primaires et donc à la charge, la densité du bombardement ionique primaire peut être augmentée à partir du point d'équilibre sans que cet équilibre soit modifié.

L'invention n'est pas limitée au mode de réalisation précisément décrit ci-dessus, et en particulier, il est possible de remplacer la focalisation électrostatique utilisant l'électrode supplémentaire E' par une focalisation magnétique. En effet, il peut y avoir un inconvénient à ce que les ions secondaires émis par l'électrodes supplémentaire soient également focalisés sur l'échantillon en même temps que l'on focalise les électrons, par la focalisation électrostatique c'est le cas notamment si des ions oxygène sont émis par l'électrode supplémentaire et que l'on cherche à mesurer les ions oxygène de l'échantillon. En effet la focalisation électrostatique agit de la même manière sur les ions et les électrons.

Si l'on recherche une action différente, le dispositif mettra en oeuvre une focalisation magnétique l'électrode supplémentaire en acier inoxydable sera remplacée par une électrode en fer doux portée à la masse au lieu du potentiel V' associée à une petite bobine pour former une petite lentille magnétique réalisant une focalisation magnétique qui agit différemment sur les ions et les électrons.

## Revendications

1. Procédé d'analyse ionique d'échantillon isolant émettant en ions secondaires positifs sous l'impact d'un faisceau de bombardement primaire d'ions positifs, ces ions secondaires positifs étant accélérés par un champ électrostatique créé dans un espace d'accélération entre une électrode d'accélération et une surface de l'échantillon portée à un potentiel positif par rapport à cette électrode, caractérisé en ce que la charge positive créée dans le champ imagé de l'échantillon est compensée par des électrons secondaires émis par l'électrode d'accélération sous l'impact de particules émises par l'échantillon, des moyens de focalisation placés dans l'espace d'accélération permettant de renvoyer sur le champ imagé la quantité d'électrons secondaires juste nécessaire à la compensation.

2. Procédé selon la revendication 1, caractérisé en ce que les moyens de focalisation sont électrostatiques et constitués d'une électrode supplémentaire (E') portée à un potentiel convenable (V').

3. Procédé selon la revendication 2, caractérisé en ce que le potentiel (V') appliqué à l'électrode supplémentaire (E') est réglable pour faire varier la quantité d'électrons secondaires renvoyés vers le champ imagé de l'échantillon et compenser exactement les charges positives créées à sa surface.

4. Procédé selon la revendication 3, caractérisé en ce que le réglage de la tension (V') appliquée à l'électrode supplémentaire (E') est effectué avec un faisceau primaire de bombardement de faible intensité, l'intensité du faisceau primaire étant ensuite augmentée jusqu'à la valeur nécessaire à l'analyse, sans que le réglage du potentiel de l'électrode supplémentaire ne soit modifié, le flux d'électrons secondaires renvoyés vers le champ imagé étant proportionnel, au flux d'ions primaires, comme la quantité de charges à compenser.

5. Procédé selon la revendication 1, caractérisé en ce que les moyens de focalisation sont magnétiques et constitués d'une électrode en fer doux portée à la masse associée à une bobine d'inductance.

6. Dispositif d'analyse ionique d'échantillon isolant pour l'analyse des ions positifs émis par le champ imagé de l'échantillon sous l'impact d'un faisceau d'ions primaires positifs, comportant une source d'ions primaires, une colonne primaire pour amener ces ions primaires sur le champ imagé de l'échantillon, un dispositif collecteur d'ions secondaires positifs comportant notamment une électrode d'accélération (E), et un spectrographe de masse (40), caractérisé en ce qu'il comporte en outre une électrode supplémentaire placée entre le dispositif collecteur et l'échantillon et susceptible d'être polarisée à une tension intermédiaire entre celle de l'électrode d'accélération et celle d'une surface de l'échantillon, et des moyens de réglage de cette tension intermédiaire formant un dispositif de focalisation électrostatique d'électrons secondaires émis par l'électrode d'accélération vers le champ imagé.

7. Dispositif d'analyse ionique d'échantillon isolant pour l'analyse des ions positifs émis par le champ imagé de l'échantillon sous l'impact d'un faisceau d'ions primaires positifs, comportant une source d'ions primaires, une colonne primaire pour amener ces ions primaires sur le champ imagé de l'échantillon, un dispositif collecteur d'ions secondaires positifs comportant notamment une électrode d'accélération (E) et un spectrographe de masse (40), caractérisé en ce qu'il comporte en outre une électrode supplémentaire en fer doux portée à la masse et associée à une bobine d'inductance formant un dispositif de focalisation magnétique d'électrons secondaires émis par l'électrode d'accélération vers le champ imagé.

## Patentansprüche

1. Ionenstrahl-Analyseverfahren für isolierende Proben, unter Beschuß durch einen Strahl von positiven Primärionen positive Sekundärionen aussenden, die durch ein elektrostatisches Feld beschleunigt werden, das in einem Beschleunigungsraum zwischen einer Beschleunigungselektrode und einer relativ zu dieser Elektrode auf ein positives Potential gebrachten Oberfläche der Probe erzeugt wird, dadurch gekennzeichnet, daß die im Bild-Feld der Probe erzeugte positive Ladung durch Sekundärelektronen kompensiert wird, die von der Beschleunigungselektrode unter der Einwirkung der von der Probe emittierten Sekundärteilchen ausgesandt werden, wobei im Beschleunigungsraum angeordnete Fokussiermittel die für die Kompensation genau erforderliche Menge an Sekundärelektronen auf das Bild-Feld senden.

2. Verfahren nach Anspruch 1, dadurch gekennzeichnet, daß die Fokussiermittel elektrostatischer Natur sind und aus einer Zusatzelektrode (E') bestehen, die auf ein passendes Potential (V') gebracht ist.

3. Verfahren nach Anspruch 2, dadurch gekennzeichnet, daß das an die Zusatzelektrode (E') angelegte Potential (V') einstellbar ist, um die Menge der auf das Bild-Feld der Probe gerichteten Sekundärelektronen zu verändern und die auf ihrer Oberfläche erzeugten positiven Ladungen genau zu kompensieren.

4. Verfahren nach Anspruch 3, dadurch gekennzeichnet, daß die Einstellung der an der Zusatzelektrode (E') angelegten Spannung (V') mit einem primären Beschußstrahl geringer Intensität erfolgt, wobei die Intensität des Primärstrahles anschließend bis auf den für die Analyse benötigten Wert gesteigert wird, ohne daß die Potentialeinstellung der Zusatzelektrode geändert wird, wobei der auf das Bild-Feld gesandte Sekundärelektronenfluß dem Primärionenfluß proportional ist, ebenso wie die zu kompensierende Ladungsmenge.

5. Verfahren nach Anspruch 1, dadurch gekennzeichnet, daß die Fokussiermittel magnetischer Natur sind und aus einer geerdeten Weicheiselenelektrode bestehen, die mit einer Induktionsspule zusammenwirkt.

6. Ionenstrahl-Analyseeinrichtung für isolierende Proben zum Analysieren der vom Bild-Feld der Probe unter der Einwirkung eines positiven Primärionenstrahles ausgesandten positiven Ionen, mit einer Primärionenquelle, einer Primärsäule, die die Primärionen in das Bild-Feld der Probe bringen, einer Kollektorvorrichtung für positive Sekundärionen, der insbesondere eine Beschleunigungselektrode (E) aufweist, und einem Massenspektrographen (40), dadurch gekennzeichnet, daß die Einrichtung weiter eine zwischen der Kollektorvorrichtung und der Probe angeordnete Zusatzelektrode, die auf eine zwischen der Spannung der Beschleunigungselektrode und derjenigen einer Oberfläche der Probe gelegene Zwischenspannung gebracht werden kann, sowie Mittel zur Einstellung dieser Zwischenspannung aufweist, welche eine Vorrichtung zur elektrostatischen Fokussierung für von der Beschleunigungselektrode in Richtung auf das Bild-Feld ausgesandten Sekundärelektronen bildet.

7. Ionenstrahl-Analyseeinrichtung für isolierende Proben zum Analysieren der vom Bild-Feld der Probe unter der Einwirkung eines positiven Primärionenstrahles ausgesandten positiven Ionen, mit einer Primärionenquelle, einer Primärsäule, die die Primärionen in das Bild-Feld der Probe bringen, einer Kollektorvorrichtung für positive Sekundärionen, der insbesondere eine Beschleunigungselektrode (E) aufweist, und einem Massenspektrographen (40), dadurch gekennzeichnet, daß die Einrichtung weiter eine geerdete und mit einer Induktionsspule versehene Weicheiselenelektrode aufweist, welche eine Einrichtung zur magnetischen Fokussierung für von der Beschleunigungselektrode in Richtung auf das Bild-Feld ausgesandte Sekundärelektronen bildet.

## Claims

1. A ionic analysis method for examining insulating samples, which emit positive secondary ions under the impact of a primary bombardment beam of positive ions, said positive secondary ions being accelerated by an electrostatic field established in an acceleration space situated between an acceleration electrode and a sample surface put to a positive potential relative to said electrode, characterized in that the positive charge created in the imaged field of the sample is compensated by secondary electrons emitted by the acceleration electrode under the impact of particles emitted by the sample, with focussing means disposed in the acceleration space allowing for directing onto the imaged field the exact amount of secondary electrons needed for compensation.

2. A method according to claim 1, characterized in that the focussing means are electrostatic ones and are constituted of a supplementary electrode (E') put to a convenient potential (V').

3. A method according to claim 2, characterized in that the potential (V') applied to the supplementary electrode (E') is adjustable in order to vary the amount of secondary electrons directed towards the imaged field of the sample and to compensate exactly the positive charges created on its surface.

4. A method according to claim 3, characterized in that the potential (V') applied to the supplementary electrode (E') is adjusted by means of a primary bombardment beam of low intensity, the intensity of the primary beam being then increased up to the value required for performing the analysis without thereby modifying the setting of the potential of the supplementary electrode, and the flux of secondary electrons directed towards the imaged field being proportional to the flux of primary ions, as is the amount of charges to be compensated.

5. A method according to claim 1, characterized in that the focussing means are magnetic ones and are constituted by a grounded soft iron electrode, associated with an inductance coil.

6. A ion analysis device for insulating samples, used to analyse positive ions emitted by the imaged field of the sample under the impact of a positive primary ion beam, comprising a primary ion source, a primary column for conveying said primary ions onto the imaged field of the sample, a collector device for collecting positive secondary ions and comprising in particular an acceleration electrode (E), and a mass spectrograph (40), characterized in that the device further comprises a supplementary electrode placed between the collector device and the sample and susceptible of being polarized to an intermediate voltage between the voltage of the acceleration electrode and the voltage of a sample surface, and means for adjusting said intermediate voltage forming an electrostatic focussing device for secondary electrons emitted by the acceleration electrode towards the imaged field.

7. A ion analysis device for insulating samples, used to analyse positive ions emitted by the imaged field of the sample under the impact of a positive primary ion beam, comprising a primary ion source, a primary column for conveying said primary ions onto the imaged field of the sample, a collector device for collecting positive secondary ions and comprising in particular an acceleration electrode, (E) and a mass spectrograph (40), characterized in that the device further comprises a supplementary grounded electrode made of soft iron and associated with an inductance coil forming a device for magnetically focussing secondary electrons emitted by the acceleration electrode towards the imaged field.

# FIG_1

SOURCE
PRIMAIRE

SPECTOGRAPHE
DE
MASSE

*40*

*10*

*1*

*2*

*30*

*E*

*E'*

+V'

*21*

*20*

+V

*50*

# FIG_2

+V

+V'

*1*

*E'*

*E*

*3*

T',d'

*4*

T,d

*2*

*22*

FENÊTRE

CHAMP
IMAGÉ

*21*

*20*

# FIG_3a

$I_e$ (e⁻)

$I_S$ (ions +)

$I_e$ (ions+)

$O$

$I_c$ (e⁻)

+V

# FIG_3b

2

FILM
CONDUCTEUR

A

⊙   $O$

1

ECHANTILLON
ISOLANT

# FIG_4a

$I_p$                    $I_c > 0$

$I_S$

$I_e$

$I_c$

+
+

# FIG_4b

$I_p$          $I_c < 0$

$I_S$

$I_e$

$I_c$

+
+